# EUROPEAN PATENT APPLICATION

(11) **EP 4 475 648 A1**
(43) Date of publication of application: **11.12.2024**
(21) Application number: 24180453.3
(22) Date of filing: 06.06.2024
(51) Int. Cl.: H10K 59/122, H10K 71/00, H10K 71/40, H10K 59/12, G03F 7/00

(54) **METHOD FOR PREPARING PIXEL DEFINING LAYER**

(30) Priority: 09.06.2023 KR 20230074505
(71) Applicant: Duksan Neolux Co., Ltd, Cheonan-si, Chungcheongnam-do (KR)
(72) Inventor: Cho, Hyunsang, Cheonan-si, Chungcheongnam-do, (KR); Kim, Kyung Soo, Cheonan-si, Chungcheongnam-do (KR)
(74) Representative: BCKIP Part mbB

(57) **Abstract**

The present disclosure is not only to ensure vivid colors, but also to increase display reliability and lifespan by creating one or more layers through one-time process of performing coating, prebaking, exposure, development, post-exposure, and post-heat treatment and thus implementing a coloring pattern capable of reducing the process time on the electrode substrate. That is, the present disclosure unifies the processes of two layers of the PDL and CS layers of the organic light emitting diode panel into one by including the colorant according to the present disclosure, and shortens the process time by adjusting the UV active ray transmittance of the photomask to three sections of 0% (non-exposed portion), 20 to 50% (Half-tone), and 100% (Full-tone) in order to create a step height in the pattern after the development process is completed and thus forming two layers at once. At this time, the present disclosure is to adjust the size of the pigment to adjust the pattern thickness, thereby implementing an organic light emitting display to not only ensure vivid colors but also increase display reliability and lifespan. In other words, since it may cause reduced visibility and reduced adhesion due to interference from external light, and reduced luminance and reduced lifespan due to residue when the thickness of the half-tone after post-heat treatment is more than 1.90 µm or less than 1.00 µm, the present disclosure is to use a pigment dispersion of which the size of a pigment used is 80 nm to 120 nm in order to adjust the thickness of the half-tone after finishing the post-heat treatment process to 1.00 µm to 1.90 µm by including the colorant according to the present disclosure.

## Description

### TECHNICAL FIELD

The present disclosure relates to a method for preparing a pixel defining layer of a light emitting display device using a photosensitive resin composition.

### BACKGROUND

As a flat panel display device, a liquid crystal display device (LCD), an organic light emitting display device (OLED), *etc.* are widely used. Among these, the organic light emitting display device has advantages such as low power consumption, a fast response speed, high color reproducibility, high luminance, and a wide viewing angle.

In the case of the organic light emitting display device, a polarizing film is used to block the light being reflected from the panel when external light is incident, and there is a disadvantage in that the polarizing film is not suitable for application to a flexible device due to a lack of bending properties.

As a method for solving the above problem, methods such as forming an inorganic film for blocking light on an upper substrate as well as a color filter and a black matrix have been proposed. However, these methods have limitations in obtaining a desired level of antireflection effect, and no specific methods for replacing the polarizing film have yet been suggested.

Meanwhile, colored patterns are used as red, green, and blue color filters not only in liquid crystal displays but also in organic light emitting displays.

When producing the coloring patterns, carbon black and inorganic pigments as well as various types of organic pigments are used as colorants, pigment dispersions in which these colorants are dispersed are mixed with other compositions to form patterns, and in order to support the metal mask for deposition before the organic light-emitting layer is deposited, a photolithography process is added, and then a deposition process is performed.

These patterns should form patterns of appropriate thickness to block light transmitted from the outside or reflected from the bottom, and organic light emitting displays made from pixels formed in this way can implement more vivid colors. However, the larger the particles of the inorganic pigments used in the colored patterns, the higher the thicknesses of the patterns, which reduces visibility, and the smaller the particles, the smaller the thicknesses of the patterns, causing a decrease in luminance reliability.

### SUMMARY

In order to solve the problems of the related art, one embodiment of the present disclosure is not only to ensure vivid colors, but also to increase display reliability and lifespan by adjusting the size of the inorganic pigment to adjust the pattern thickness and thus implementing an organic light emitting display.

Another embodiment is not only to ensure vivid colors, but also to increase display reliability and lifespan by integrating the process for creating two layers into one process in order to reduce damage to the panel and thus implementing a coloring pattern with a short process time on the electrode substrate.

In other words, if the irradiation amount is changed by lowering the transmittance of some sections of a negative type photo mask that cures by transmitting light, the degree of curing varies depending on the irradiation amount after development, forming a step height in the pattern, and an object of the present disclosure is to implement two layers in one process.

Another embodiment is to provide an organic light emitting display device including a pixel defining layer prepared by the above method.

Still another embodiment is to provide an electronic device including the organic light emitting display device.

Preferable is a method for preparing a pixel defining layer according to the present disclosure, the method including steps of: applying and coating a photosensitive resin composition containing a colorant with an average particle size of 60 nm to 140 nm; performing prebaking; performing exposure; performing development; performing post-exposure; and performing post-heat treatment, wherein the post-heat treatment step is performed at an oven temperature of 200°C to 300°C for 30 to 120 minutes, the full-tone thickness after the post-heat treatment step is 2.80 µm to 3.20 µm, the half-tone thickness after the post-heat treatment step is 1.00 µm to 1.90 µm, and there is no residue.

It is more preferable that the average particle size is 70 nm to 130 nm.

It is further more preferable that the average particle size is 80 nm to 120 nm.

It is preferable that the colorant includes one or more of an inorganic dye, an organic dye, an inorganic pigment, and an organic pigment.

It is preferable that the colorant is contained in an amount of 1 to 40% by weight based on the total amount of the photosensitive resin composition.

It is preferable that the colorant is pretreated using a dispersant; or a water-soluble inorganic salt and a wetting agent.

It is preferable that the half-tone thickness of the pattern after the development step is 1.40 to 2.00 µm.

It is more preferable that the full-tone thickness of the pattern after the development step is 3.20 to 3.42 µm.

It is preferable that the half-tone thickness of the pattern after the post-heat treatment step is 1.20 to 1.80 µm.

It is more preferable that the full-tone thickness of the pattern after the post-heat treatment step is 2.90 to 3.10 µm.

It is more preferable that the hot plate temperature in the prebaking step is 90°C to 120°C.

It is more preferable that the prebaking step is performed for 100 to 150 seconds.

It is more preferred that the development step is performed for 35 to 55 seconds.

It is more preferable to irradiate active rays of 100 to 900 mJ/cm² in the post-exposure step.

It is more preferable that the temperature in the post-heat treatment step is 230 to 270°C.

It is preferable that the photosensitive resin composition includes a patterning resin which includes an acrylic binder resin, a cardo-based binder resin, or a combination thereof.

It is preferable that the acrylic binder resin has a weight average molecular weight of 3,000 g/mol to 150,000 g/mol.

It is preferable that the cardo-based binder resin includes a repeating structure of Formula 1 below.

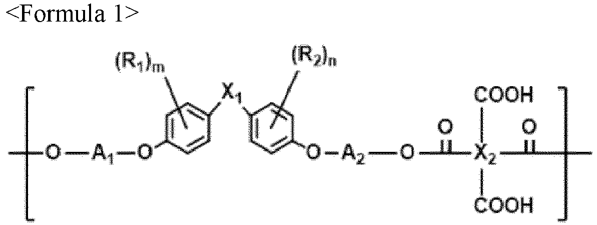

In Formula 1,
1) R¹ and R² are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
2) R¹ and R² can form a ring between neighboring groups,
3) m and n are each independently an integer of 0 to 4,
4) A₁ and A₂ are each independently Formula 2 or Formula 3 below,

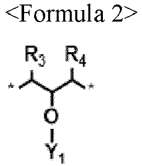

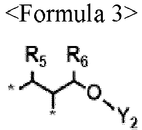

In Formula 2 and Formula 3,
4-1) * indicates a connection part,
4-2) R³ to R⁶ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-3) R³ to R⁶ can form a ring between neighboring groups,
4-4) Y¹ and Y² are each independently Formula 6 or Formula 7 below,

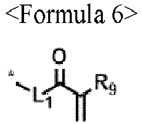

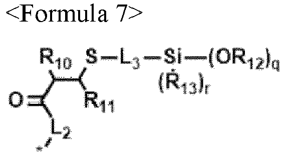

In Formula 6 and Formula 7,
4-4-1) * indicates a binding position,
4-4-2) R⁹ is hydrogen or methyl,
4-4-3) R¹⁰ to R¹³ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-4-4) L¹ to L³ are each independently a single bond; a fluorenylene group; C₂-C₃₀ alkylene; C₆-C₃₀ arylene; C₂-C₃₀ heterocycle; C₁-C₃₀ alkoxylene; C₂-C₃₀ alkyleneoxy; a C₆-C₃₀ aryloxy group; or a C₂-C₃₀ polyethyleneoxy group,
4-4-5) q and r are each independently an integer of 0 to 3; with the proviso that q+r = 3, and
5) the ratio of A₁ and A₂ in the polymer chain of the resin including a repeating unit represented by Formula 1 is 9:1 to 1:9,
6) X¹ is a single bond; O; CO; SO₂; CR'R"; SiR'R"; Formula 4 below; or Formula 5 below,
6-1) R' and R" are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-2) R' and R" can form a ring between adjacent groups,

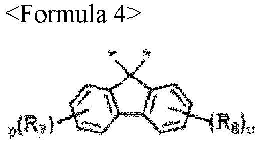

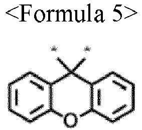

In Formula 4 and Formula 5,
6-3) * indicates a binding position,
6-4) R⁷ and R⁸ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-5) o and p are each independently an integer of 0~4,
7) X² is a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenylene group; a carbonyl group; an ether group; or a C₁-C₂₀ alkoxycarbonyl group, and
8) R', R", X², L¹ to L³, R¹ to R⁸, and R¹⁰ to R¹³ may each be further substituted with one or more substituents selected from the group consisting of deuterium; a halogen; a silane group substituted or unsubstituted with a C₁-C₃₀ alkyl group or C₆-C₃₀ aryl group; a siloxane group; a boron group; a germanium group; a cyano group; an amino group; a nitro group; a C₁-C₃₀ alkylthio group; a C₁-C₃₀ alkoxy group; a C₆-C₃₀ arylalkoxy group; a C₁-C₃₀ alkyl group; a C₂-C₃₀ alkenyl group; a C₂-C₃₀ alkynyl group; a C₆-C₃₀ aryl group; a C₆-C₃₀ aryl group substituted with deuterium; a fluorenyl group; a C₂-C₃₀ heterocyclic group containing at least one heteroatom selected from the group consisting of O, N, S, Si, and P; a C₃-C₃₀ alicyclic group; a C₇-C₃₀ arylalkyl group; a C₈-C₃₀ arylalkenyl group; and combinations thereof, or may form a ring between adjacent substituents.

It is preferable that the cardo-based resin has a weight average molecular weight of 1,000 to 100,000 g/mol.

It is preferable that the cardo-based resin is contained in an amount of 1 to 30% by weight based on the total amount of the photosensitive resin composition.

It is preferable that the photosensitive resin composition includes a reactive unsaturated compound in an amount of 1 to 40% by weight based on the total amount of the photosensitive resin composition.

It is preferable that the photosensitive resin composition includes a photoinitiator in an amount of 0.01 to 10% by weight based on the total amount of the photosensitive resin composition.

In still another embodiment, it is preferable that the present disclosure provides a pixel defining layer prepared according to the above preparation method.

In still another embodiment, it is preferable that the present disclosure provides an organic light emitting display device including the pixel defining layer.

In still another embodiment, it is preferable that the present disclosure provides an electronic device including the display device and a control unit for driving the display device.

### ADVANTAGEOUS EFFECTS

The present disclosure is not only to ensure vivid colors, but also to increase display reliability and lifespan by implementing a coloring pattern of appropriate thickness on an electrode substrate. In other words, since it may cause reduced adhesion, reduced visibility, reduced luminance, and reduced lifespan in the post-process if the thickness of the half-tone after post-heat treatment is more than 1.90 µm or less than 1.00 µm, and in order to increase visibility and lower reduced luminance and reduced lifespan after completing the post-heat treatment process by including the colorant according to the present disclosure, the inorganic pigment used is prepared to a size of 80 nm to 120 nm.

### BRIEF DESCRIPTION OF THE DRAWINGS

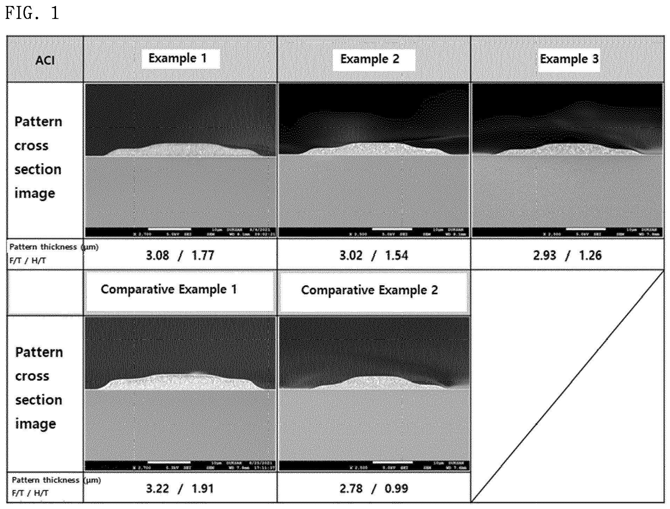

FIG. 1 schematically shows cross-sections of pixel defining layers of Examples and Comparative Examples by photographing them with a scanning electron microscope.

### DETAILED DESCRIPTION

Hereinafter, some embodiments of the present disclosure will be described in detail with reference to exemplary drawings. In adding reference numerals to components of each drawing, the same components may have the same reference numerals as far as possible even though they are indicated in different drawings.

When it is determined that a detailed description of a related known constitution or function may obscure the gist of the present disclosure in describing the present disclosure, the detailed description thereof may be omitted. When the expressions "includes", "has", "consisting of", *etc.* mentioned in this specification are used, other parts may be added unless "only" is used. When a component is expressed in the singular form, it may include a case in which the plural form is included unless otherwise explicitly stated.

In addition, in describing the components of the present disclosure, terms such as first, second, A, B, (a), (b), etc. may be used. Such terms are only for distinguishing the components from other components, and the essence, order, sequence, number, or etc. of the relevant components are not limited by the terms.

In the description of the positional relationship of the components, when two or more components are described as being "connected", "linked", or "fused", etc., the two or more components may be directly "connected", "linked", or "fused", but it should be understood that the two or more components may also be "connected", "linked", or "fused" by way of a further "interposition" of a different component. Here, the different component may be included in any one or more of the two or more components that are to be "connected", "linked", or "fused" to each other.

In addition, when a component such as a layer, a film, a region, a plate, or *etc.* is described to be "on top" or "on" of another component, it should be understood that this may not only include a case where the component is "immediately on top of" another component, but also include a case where another component is disposed therebetween. In contrast, it should be understood that when a component is described to be "immediately on top of" another part, this may mean that there is not another part disposed therebetween.

In the description of the temporal flow relationship relating to the components, the operation method, or the preparation method, for example, when the temporal precedence or flow precedence is described by way of "after", "subsequently", "thereafter", "before", *etc.,* it may also include cases where the flow is not continuous unless terms such as "immediately" or "directly" are used.

Meanwhile, when the reference is made to numerical values or corresponding information for components, numerical values or corresponding information may be interpreted as including an error range that may occur due to various factors (e.g., process factors, internal or external shocks, noise, etc.) even if a separate explicit description is not present.

The terms used in this specification and the appended claims are as follows unless otherwise stated without departing from the spirit of the present disclosure.

The term used in this application "halo" or "halogen" includes fluorine (F), chlorine (Cl), bromine (Br), and iodine (I) unless otherwise specified.

The term used in this application "alkyl" or "alkyl group" refers to a radical of saturated aliphatic functional groups having 1 to 60 carbons linked by a single bond unless otherwise specified, and including a linear chain alkyl group, a branched chain alkyl group, a cycloalkyl (alicyclic) group, an alkyl-substituted cycloalkyl group, and a cycloalkyl-substituted alkyl group.

The term used in this application "haloalkyl group" or "halogenalkyl group" refers to an alkyl group in which a halogen is substituted unless otherwise specified.

The term used in this application "alkenyl" or "alkynyl", unless otherwise specified, has a double bond or triple bond, respectively, includes a linear or branched chain group, and has 2 to 60 carbon atoms, but is not limited thereto.

The term used in this application "cycloalkyl" refers to alkyl which forms a ring having 3 to 60 carbon atoms unless otherwise specified, but is not limited thereto.

The term used in this application "alkoxy group" or "alkyloxy group" refers to an alkyl group to which an oxygen radical is bonded, and has 1 to 60 carbon atoms unless otherwise specified, but is not limited thereto.

The term used in this application "alkenoxyl group", "alkenoxy group", "alkenyloxyl group", or "alkenyloxy group" refers to an alkenyl group to which an oxygen radical is attached, and has 2 to 60 carbon atoms unless otherwise specified, but is not limited thereto.

The term used in this application "aryl group" and "arylene group" each have 6 to 60 carbon atoms unless otherwise specified, but are not limited thereto. The aryl group or arylene group in this application includes monocyclic compounds, ring assemblies, multiple fused cyclic compounds, etc. For example, the aryl group may include a phenyl group, a monovalent functional group of biphenyl, a monovalent functional group of naphthalene, a fluorenyl group, and a substituted fluorenyl group, and the arylene group may include a fluorenylene group and a substituted fluorenylene group.

The term used in this application "ring assemblies" means that two or more ring systems (monocyclic or fused ring systems) are directly connected to each other through a single bond or double bond, and the number of direct links between such rings is one less than the total number of ring systems contained in the compound. In the ring assemblies, the same or different ring systems may be directly connected to each other through a single bond or double bond.

Since the aryl group in this application includes ring assemblies, the aryl group includes biphenyl and terphenyl in which a benzene ring, which is a single aromatic ring, is connected by a single bond. In addition, since the aryl group also includes a compound in which an aromatic ring system fused to an aromatic single ring is connected by a single bond, it also includes, for example, a compound in which a benzene ring, which is an aromatic single ring, and fluorine, which is a fused aromatic ring system, are linked by a single bond.

The term used in this application "multiple fused ring systems" refers to a fused ring form in which at least two atoms are shared, and it includes a form in which ring systems of two or more hydrocarbons are fused, a form in which at least one heterocyclic system including at least one heteroatom is fused, *etc.* Such multiple fused ring systems may be an aromatic ring, a heteroaromatic ring, an aliphatic ring, or a combination of these rings. For example, in the case of an aryl group, it may be a naphthalenyl group, a phenanthrenyl group, a fluorenyl group, *etc.,* but is not limited thereto.

The term used in this application "a spiro compound" has "a spiro union", and the spiro union refers to a linkage in which two rings are formed by sharing only one atom. At this time, the atom shared by the two rings is called a "spiro atom", and they are each called "monospiro-", "dispiro-", and "trispiro-" compounds depending on the number of spiro atoms included in a compound.

The terms used in this application "fluorenyl group", "fluorenylene group", and "fluorenetriyl group" refer to a monovalent, divalent, or trivalent functional group in which R, R', R", and R‴ are all hydrogen in the following structures, respectively, unless otherwise specified, "substituted fluorenyl group", "substituted fluorenylene group", or "substituted fluorenetriyl group" means that at least one of the substituents R, R', R", and R‴ is a substituent other than hydrogen, and cases where R and R' are bound to each other to form a spiro compound together with carbon to which they are linked are included. In this specification, all of the fluorenyl group, the fluorenylene group, and the fluorenetriyl group may also be referred to as a fluorene group regardless of valences such as monovalent, divalent, trivalent, *etc.*

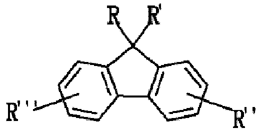

In addition, R, R', R", and R‴ may each independently be an alkyl group having 1 to 20 carbon atoms, an alkenyl group having 1 to 20 carbon atoms, an aryl group having 6 to 30 carbon atoms, and a heterocyclic group having 2 to 30 carbon atoms and, for example, the aryl group may be phenyl, biphenyl, naphthalene, anthracene, or phenanthrene, and the heterocyclic group may be pyrrole, furan, thiophene, pyrazole, imidazole, triazole, pyridine, pyrimidine, pyridazine, pyrazine, triazine, indole, benzofuran, quinazoline, or quinoxaline. For example, the substituted fluorenyl group and the fluorenylene group may each be a monovalent functional group or divalent functional group of 9,9-dimethylfluorene, 9,9-diphenylfluorene, and 9,9'-spirobi [9H-fluorene] .

The term used in this application "heterocyclic group" includes not only an aromatic ring such as "heteroaryl group" or "heteroarylene group", but also a non-aromatic ring, and refers to a ring having 2 to 60 carbon atoms each including one or more heteroatoms unless otherwise specified, but is not limited thereto. The term used in this application "heteroatom" refers to N, O, S, P, or Si unless otherwise specified, and the heterocyclic group refers to a monocyclic group including a heteroatom, ring assemblies, multiple fused ring systems, spiro compounds, *etc.*

For example, the "heterocyclic group" may also include a compound including a heteroatom group such as SO₂, P=O, *etc.* such as the compound shown below, instead of carbon that forms a ring.

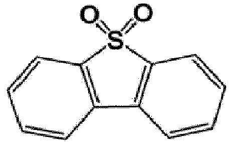

The term used in this application "ring" includes monocyclic and polycyclic rings, includes heterocycles containing at least one heteroatom as well as hydrocarbon rings, and includes aromatic and non-aromatic rings.

The term used in this application "polycyclic" includes ring assemblies such as biphenyl, terphenyl, *etc.,* multiple fused ring systems, and spiro compounds, includes non-aromatic as well as aromatic compounds, and includes heterocycles containing at least one heteroatom as well as hydrocarbon rings.

The term used in this application "alicyclic group" refers to cyclic hydrocarbons other than aromatic hydrocarbons, includes monocyclic compounds, ring assemblies, multiple fused ring systems, spiro compounds, *etc.,* and refers to a ring having 3 to 60 carbon atoms unless otherwise specified, but is not limited thereto. For example, even when benzene, which is an aromatic ring, and cyclohexane, which is a non-aromatic ring, are fused, the alicyclic group corresponds to an aliphatic ring.

In addition, when prefixes are named consecutively, it means that the substituents are listed in the order they are described. For example, in the case of an arylalkoxy group, it means an alkoxy group substituted with an aryl group, in the case of an alkoxycarbonyl group, it means a carbonyl group substituted with an alkoxy group, and further in the case of an arylcarbonyl alkenyl group, it means an alkenyl group substituted with an arylcarbonyl group, wherein the arylcarbonyl group is a carbonyl group substituted with an aryl group.

In addition, unless otherwise explicitly specified, "substituted" in the term used in this application "substituted or unsubstituted" refers to a substitution with one or more substituents selected from the group consisting of deuterium, a halogen, an amino group, a nitrile group, a nitro group, a C₁-C₃₀ alkyl group, a C₁-C₃₀ alkoxy group, a C₁-C₃₀ alkylamine group, a C₁-C₃₀ alkylthiophene group, a C₆-C₃₀ arylthiophene group, a C₂-C₃₀ alkenyl group, a C₂-C₃₀ alkynyl group, a C₃-C₃₀ cycloalkyl group, a C₆-C₃₀ aryl group, a C₆-C₃₀ aryl group substituted with deuterium, a C₈-C₃₀ arylalkenyl group, a silane group, a boron group, a germanium group, and a C₂-C₂₀ heterocyclic group containing at least one heteroatom selected from the group consisting of O, N, S, Si, and P, but is not limited to these substituents.

Although the "names of functional groups" corresponding to the aryl group, arylene group, heterocyclic group, etc. exemplified as examples of each symbol and a substituent thereof in this application may be described as "names of the functional groups reflecting their valences", they may also be described as the "names of their parent compounds". For example, in the case of "phenanthrene", which is a type of an aryl group, the names of the groups may also be described such that the monovalent "group" is divided and described as "phenanthryl (group)", and the divalent "group" is divided and described as "phenanthrylene (group)", etc., but may also be described as "phenanthrene", which is the name of its parent compound regardless of its valence.

Similarly, in the case of pyrimidine as well, it may be described as "pyrimidine" regardless of its valence, or it may also be described as the "name of the group" of the relevant valence such as pyrimidinyl (group) in the case of monovalent and pyrimidinylene (group) in the case of divalent. Therefore, when the type of a substituent in this application is described as the name of its parent compound, it may refer to an n-valent "group" formed by detachment of a hydrogen atom bonded to a carbon atom and/or hetero atom of its parent compound.

In addition, in describing the names of the compounds or the substituents in this specification, the numbers, alphabets, *etc.* indicating positions may be omitted. For example, pyrido[4,3-d]pyrimidine may be described as pyridopyrimidine, benzofuro[2,3-d]pyrimidine may be described as benzofuropyrimidine, and 9,9-dimethyl-9H-fluorene may be described as dimethylfluorene. Therefore, both benzo[g]quinoxaline and benzo[f]quinoxaline may be described as benzoquinoxaline.

In addition, unless there is an explicit description, the formulas used in this application are applied in the same manner as in the definition of substituents by the exponent definition of the formula below.

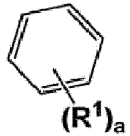

Here, when a is an integer of 0, it means that the substituent R1 is not present, that is, when a is 0, it means that hydrogen is bonded to all carbons that form a benzene ring, and at this time, the indication of hydrogen bonded to carbons may be omitted, and the formula or compound may be described. In addition, when a is an integer of 1, one substituent R¹ may be bonded to any one of carbons forming a benzene ring, when a is an integer of 2 or 3, it may be bonded, for example, as shown below, even when a is an integer of 4 to 6, it may be bonded to carbons of a benzene ring in a similar manner, and when a is an integer of 2 or more, R¹ may be the same as or different from each other.

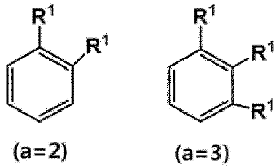

Unless otherwise specified in the present application, forming a ring means that adjacent groups bind to one another to form a single ring or multiple fused rings, and the single ring and the formed multiple fused rings may include a heterocycle containing at least one heteroatom as well as a hydrocarbon ring, and include aromatic and non-aromatic rings.

In addition, unless otherwise specified in this specification, when indicating a condensed ring, the number in "number-condensed ring" indicates the number of rings to be condensed. For example, a form in which three rings such as anthracene, phenanthrene, benzoquinazoline, *etc.* are condensed with one another may be marked as a 3-condensed ring.

Meanwhile, the term used in this application "bridged bicyclic compound" refers to a compound in which two rings share 3 or more atoms to form a ring unless otherwise specified. At this time, the shared atoms may include carbon or a hetero atom.

An organic electric device in this application may refer to a component(s) between a positive electrode and a negative electrode, or may refer to an organic light emitting diode which includes a positive electrode, a negative electrode, and a component(s) positioned therebetween.

In addition, in some cases, the display device in this application may refer to an organic electric device, an organic light emitting diode, and a panel including the same, or may refer to an electronic device including a panel and a circuit. Here, for example, the electronic device may include all of a lighting device, a solar cell, a portable or mobile terminal (e.g., a smart phone, a tablet, a PDA, an electronic dictionary, a PMP, *etc.*)*,* a navigation terminal, a game machine, various TV sets, various computer monitors, *etc.,* but is not limited thereto, and may be any type of device as long as it includes the component(s).

Hereinafter, embodiments of the present disclosure will be described in detail. However, these embodiments are presented as examples, and the present disclosure is not limited thereby, and the present disclosure is only defined by the scope of the claims to be described later.

The composition containing a colorant according to one embodiment of the present disclosure may be used to prepare a pixel defining layer (PDL) with a red pattern, a green pattern, a blue pattern, or a black matrix.

A black pixel defining layer (PDL) according to one embodiment of the present disclosure may further contain an organic black pigment or black dye as an additional coloring material other than a coloring material included in the colorant described above. For example, an organic pigment may be used alone, or a mixture of an organic pigment and a coloring pigment may be used. At this time, there is an advantage in that the strength of the film (layer) or the adhesion to the substrate is not reduced even when the amount of the coloring material is relatively increased since a coloring pigment that is lack in light blocking properties is mixed. The negative pixel defining layer (PDL) according to one embodiment of the present disclosure may contain a black pigment or black dye as an additional coloring material instead of a coloring material included in the colorant described above.

Hereinafter, each component will be described in detail.

### 1. The process of preparing a negative pixel defining layer is as follows.

### (1) Application and coating step

A photosensitive resin composition is a low-viscosity liquid sample, and a spin coater or slit coater is used in order to coat the photosensitive resin composition to a certain thickness after applying the photosensitive resin composition onto a substrate. The spin coater has an advantage in that the flatness deviation in the area decreases although the thickness is decreased as the number of revolutions increases, and a slit coater is preferable to a spin coater in order to coat the photosensitive resin composition on a large area substrate. Due to the solvent remaining after coating, the surface may have fluidity, and there is a disadvantage in that flatness deteriorates due to this, and in order to overcome the disadvantage, the fluidity on the surface is lowered by removing a portion of the solvent using vacuum chamber dry (VCD).

### (2) Pre-baking step

This is a process of removing a portion of the solvent contained in the coating film by heating the coated substrate with a hot plate or an oven at a predetermined temperature and time. When the surface or core part of the coating film is not dried, photomask contamination occurs during exposure in the next process, and when irradiated with ultraviolet light, the exposed portion does not cure well, and the pattern is not formed and removed in the developing process due to non-curing.

### (3) Exposure step

This is a process of curing a formed film by irradiating active rays (ultraviolet rays) using a photomask in which a pattern is formed when the pre-bake process is finished. Types of lamps that generate active rays include LED lamps or metal (mercury) lamps, and wavelengths include g-line (436 nm), h-line (405 nm), i-line (365 nm), and deep UV (<260 nm), which can be used individually or in a mixed form.

### (4) Development step

When irradiating active rays in the exposure step, the formed film is divided into an exposed portion and a non-exposed portion by the photo mask, and in the case of the positive type, the exposed portion is melted by a developer, and the non-exposed portion withstands the developer and the pattern remains. In the case of the negative type, the exposed portion is cured and has resistance to the developer, and the non-exposed portion is developed. The black pixel defining layer (PDL), which is prepared from a composition containing a colorant of the present disclosure, is a negative type and divided into the exposed portion (curing) and the non-exposed portion (development) to form a pattern.

### (5) Post-exposure step

This is a process of further curing the formed film by irradiating the pattern-formed substrate with active rays (ultraviolet rays) once again after the development process is finished. Types of lamps that generate active rays include LED lamps or metal (mercury) lamps, and the wavelengths include g-line (436 nm), h-line (405 nm), i-line (365 nm), and deep UV (<260nm), which can be used individually or in a mixed form.

### (6) Post-heat treatment step

This is a process of removing the remaining solvent and fume by heating the developed substrate at a high temperature of 200°C or higher to 300°C or lower. If the solvent and fume are not completely removed in the relevant process, outgases are generated in the post-heat treatment process to affect the device so that dark spots or pixel shrinkage may be affected due to this.

### 2. A composition forming a negative pixel defining layer containing a colorant is as follows.

### (1) Patterning resin

The patterning resin according to one embodiment of the present disclosure may include an acrylic binder resin, a cardo-based binder resin, or a combination thereof.

The acrylic binder resin is a copolymer of a first ethylenically unsaturated monomer and a second ethylenically unsaturated monomer copolymerizable therewith, and is a resin including one or more acrylic repeating units.

The first ethylenically unsaturated monomer is an ethylenically unsaturated monomer containing one or more carboxyl groups, and specific examples thereof may include acrylic acid, methacrylic acid, maleic acid, itaconic acid, fumaric acid, or combinations thereof. The first ethylenically unsaturated monomer may be contained in an amount of 5 to 50% by weight, for example, 10 to 40% by weight based on the total amount of the acrylic binder resin.

The second ethylenically unsaturated monomer may include aromatic vinyl compounds such as styrene, α-methylstyrene, vinyltoluene, vinylbenzyl methyl ether, *etc.;* unsaturated carboxylic acid ester compounds such as methyl (meth)acrylate, ethyl (meth)acrylate, butyl (meth)acrylate, 2-hydroxyethyl (meth)acrylate, 2-hydroxy butyl (meth)acrylate, benzyl (meth)acrylate, cyclohexyl (meth)acrylate, phenyl (meth)acrylate, *etc*.; unsaturated carboxylic acid amino alkyl ester compounds such as 2-aminoethyl (meth)acrylate, 2-dimethylaminoethyl (meth)acrylate, *etc*.; carboxylic acid vinyl ester compounds such as vinyl acetate, *etc.;* unsaturated carboxylic acid glycidyl ester compounds such as glycidyl (meth)acrylate, *etc*.; vinyl cyanide compounds such as (meth)acrylonitrile, *etc.;* and unsaturated amide compounds such as (meth)acrylamide, *etc.,* and these may be used alone or in mixtures of two or more.

Specific examples of the acrylic binder resin may include a (meth)acrylic acid/benzyl methacrylate copolymer, a (meth)acrylic acid/benzyl methacrylate/styrene copolymer, a (meth)acrylic acid/benzyl methacrylate/2-hydroxyethyl methacrylate copolymer, a (meth)acrylic acid/benzyl methacrylate/styrene/2-hydroxyethyl methacrylate copolymer, *etc.,* but are not limited thereto. These may be used alone or in a mixture of two or more. The acrylic binder resin may have a weight average molecular weight of 3,000 g/mol to 150,000 g/mol, for example, 5,000 g/mol to 50,000 g/mol, for example, 20,000 g/mol to 30,000 g/mol.

The cardo-based resin includes a repeating structure such as Formula 1 below. 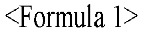 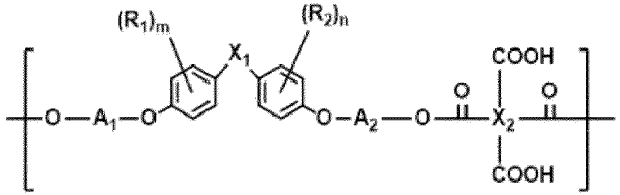 In Formula 1,
1) R¹ and R² are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
2) R¹ and R² can form a ring between neighboring groups,
3) m and n are each independently an integer of 0 to 4,
4) A₁ and A₂ are each independently Formula 2 or Formula 3 below,

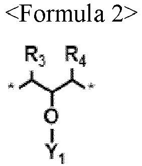

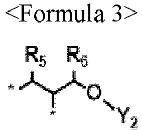

In Formula 2 and Formula 3,
4-1) * indicates a connection part,
4-2) R³ to R⁶ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-3) R³ to R⁶ can form a ring between neighboring groups,
4-4) Y¹ and Y² are each independently Formula 6 or Formula 7 below,

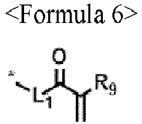

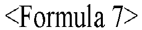

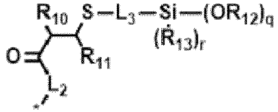

In Formula 6 and Formula 7,
4-4-1) * indicates a binding position,
4-4-2) R⁹ is hydrogen or methyl,
4-4-3) R¹⁰ to R¹³ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
4-4-4) L¹ to L³ are each independently a single bond; a fluorenylene group; C₂-C₃₀ alkylene; C₆-C₃₀ arylene; C₂-C₃₀ heterocycle; C₁-C₃₀ alkoxylene; C₂-C₃₀ alkyleneoxy; a C₆-C₃₀ aryloxy group; or a C₂-C₃₀ polyethyleneoxy group,
4-4-5) q and r are each independently an integer of 0 to 3; with the proviso that q+r = 3, and
5) the ratio of A₁ and A₂ in the polymer chain of the resin including a repeating unit represented by Formula 1 is 9:1 to 1:9,
6) X¹ is a single bond; O; CO; SO₂; CR'R"; SiR'R"; Formula 4 below; or Formula 5 below,
6-1) R' and R" are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-2) R' and R" can form a ring between adjacent groups,

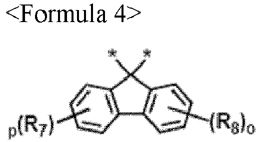

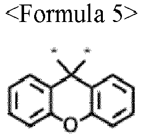

In Formula 4 and Formula 5,
6-3) * indicates a binding position,
6-4) R⁷ and R⁸ are each independently hydrogen; deuterium; a halogen; a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenyl group; a carbonyl group; an ether group; or a C₁-C₂₀ alkoxycarbonyl group,
6-5) o and p are each independently an integer of 0~4,
7) X² is a C₆-C₃₀ aryl group; a C₂-C₃₀ heterocyclic group containing at least one heteroatom of O, N, S, Si, and P; a fused ring group of a C₆-C₃₀ aliphatic ring and a C₆-C₃₀ aromatic ring; a C₁-C₂₀ alkyl group; a C₂-C₂₀ alkenyl group; a C₂-C₂₀ alkynyl group; a C₁-C₂₀ alkoxy group; a C₆-C₃₀ aryloxy group; a fluorenylene group; a carbonyl group; an ether group; or a C₁-C₂₀ alkoxycarbonyl group, and
8) R', R", X², L¹ to L³, R¹ to R⁸, and R¹⁰ to R¹³ may each be further substituted with one or more substituents selected from the group consisting of deuterium; a halogen; a silane group substituted or unsubstituted with a C₁-C₃₀ alkyl group or C₆-C₃₀ aryl group; a siloxane group; a boron group; a germanium group; a cyano group; an amino group; a nitro group; a C₁-C₃₀ alkylthio group; a C₁-C₃₀ alkoxy group; a C₆-C₃₀ arylalkoxy group; a C₁-C₃₀ alkyl group; a C₂-C₃₀ alkenyl group; a C₂-C₃₀ alkynyl group; a C₆-C₃₀ aryl group; a C₆-C₃₀ aryl group substituted with deuterium; a fluorenyl group; a C₂-C₃₀ heterocyclic group containing at least one heteroatom selected from the group consisting of O, N, S, Si, and P; a C₃-C₃₀ alicyclic group; a C₇-C₃₀ arylalkyl group; a C₈-C₃₀ arylalkenyl group; and combinations thereof, or may form a ring between adjacent substituents.

When R', R", X², L¹ to L³, R¹ to R⁸, and R¹⁰ to R¹³ are an aryl group, they may preferably be a C₆-C₃₀ aryl group, and more preferably a C₆-C₁₈ aryl group, for example, phenyl, biphenyl, naphthyl, terphenyl, *etc.*

When R', R", X², L¹ to L³, R¹ to R⁸, and R¹⁰ to R¹³ are a heterocyclic group, they may preferably be a C₂-C₃₀ heterocyclic group, and more preferably a C₂-C₁₈ heterocyclic group, for example, dibenzofuran, dibenzothiophene, naphthobenzothiophene, naphthobenzofuran, *etc.*

When R', R", R¹ to R⁸, and R¹⁰ to R¹³ are a fluorenyl group, they may preferably be 9,9-dimethyl-9H-fluorene, 9,9-diphenyl-9H-fluorenyl group, 9,9'-spirobifluorene, *etc.*

When L¹ to L³ are an arylene group, they may preferably be a C₆-C₃₀ arylene group, and more preferably a C₆-C₁₈ arylene group, for example, phenyl, biphenyl, naphthyl, terphenyl, *etc.*

When R', R", X², R¹ to R⁸, and R¹⁰ to R¹³ are an alkyl group, they may preferably be a C₁-C₁₀ alkyl group, for example, methyl, t-butyl, *etc.*

When R', R", X², R¹ to R⁸, and R¹⁰ to R¹³ are an alkoxyl group, they may preferably be a C₁-C₂₀ alkoxyl group, and more preferably a C₁-C₁₀ alkoxyl group, for example, methoxy, t-butoxy, *etc.*

Rings formed by binding between neighboring groups of R', R", X², L¹ to L³, R¹ to R⁸, and R¹⁰ to R¹³ may be a C₆-C₃₀ aromatic ring; a fluorenyl group; a C₂-C₆₀ heterocyclic group containing at least one heteroatom of O, N, S, Si, and P; or a C₃₋C₆₀ alicyclic group, and for example, when the neighboring groups bind with each other to form an aromatic ring, preferably, a C₆-C₂₀ aromatic ring, and more preferably a C₆-₁₄ aromatic ring, for example, benzene, naphthalene, phenanthrene, *etc.* may be formed.

The cardo-based resin may be prepared by mixing two or more of, for example, fluorene-containing compounds such as 9,9-*bis*(4-oxiranylmethoxyphenyl)fluorene, *etc.;* anhydride compounds such as a benzene tetracarboxylic acid dianhydride, a naphthalene tetracarboxylic acid dianhydride, a biphenyltetracarboxylic acid dianhydride, a benzophenonetetracarboxylic acid dianhydride, a pyromellitic acid dianhydride, a cyclobutanetetracarboxylic acid dianhydride, a perylenetetracarboxylic acid dianhydride, a tetrahydrofurantetracarboxylic acid dianhydride, a tetrahydrophthalic acid anhydride, *etc.;* glycol compounds such as ethylene glycol, propylene glycol, polyethylene glycol, *etc.;* alcohol compounds such as methanol, ethanol, propanol, *n*-butanol, cyclohexanol, benzyl alcohol, *etc.;* solvent compounds such as propylene glycol methylethyl acetate, *N*-methylpyrrolidone, *etc.;* phosphorus compounds such as triphenylphosphine, *etc.;* and amine or ammonium salt compounds such as tetramethylammonium chloride, tetraethylammonium bromide, benzyldiethylamine, triethylamine, tributylamine, benzyltriethylammonium chloride, *etc.*

The cardo-based resin may have a weight average molecular weight of 1,000 g/mol to 100,000 g/mol, preferably 1,000 to 50,000 g/mol, and more preferably 1,000 g/mol to 30,000 g/mol. When the weight average molecular weight of the resin is within the above range, the pattern formation is well performed without residue during the preparation of a light blocking layer, there is no loss of film thickness during development, and a good pattern may be obtained. The resin may be contained in an amount of 1 to 30% by weight, and more preferably 3 to 20% by weight based on the total amount of the photosensitive resin composition. When the resin is contained within the above range, excellent sensitivity, developing properties, and adhesiveness (adhesion) can be obtained.

### (2) Reactive unsaturated compound

A reactive unsaturated compound that is absolutely necessary for negative patterns may form a pattern having excellent heat resistance, light resistance, and chemical resistance by causing sufficient polymerization during exposure in the pattern forming process by having an ethylenically unsaturated double bond.

Specific examples of the reactive unsaturated compound may include ethylene glycol diacrylate, ethylene glycol dimethacrylate, diethylene glycol diacrylate, triethylene glycol diacrylate, triethylene glycol dimethacrylate, 1,6-hexanediol diacrylate, 1,6-hexanediol dimethacrylate, pentaerythritol triacrylate, dipentaerythritol pentaacrylate, dipentaerythritol hexaacrylate, bisphenol A epoxy acrylate, ethylene glycol monomethyl ether acrylate, trimethylolpropane triacrylate, tripentaerythritol octaacrylate, *etc.*

Examples of commercially available products of the reactive unsaturated compound are as follows.

Examples of a bifunctional ester of (meth)acrylic acid may include Aronix M-210, M-240, M-6200, *etc.* of Toa Kosei Kagaku Kogyo Co., Ltd, KAYARAD HDDA, HX-220, R-604, *etc.* of Nippon Kayaku Co., Ltd, and V-260, V-312, V-335 HP, *etc.* of Osaka Yuki Kagaku Kogyo Co., Ltd.

Examples of a trifunctional ester of (meth)acrylic acid may include Aronix M-309, M-400, M-405, M-450, M-7100, M-8030, M-8060, *etc.* of Toa Kosei Kagaku Kogyo Co., Ltd, KAYARAD TMPTA, DPCA-20, DPCA-60, DPCA-120, *etc.* of Nippon Kayaku Co., Ltd, and V-295, V-300, V-360, *etc.* of Osaka Yuki Kagaku Kogyo Co., Ltd.

The above products may be used alone or used together in combinations of two or more.

The reactive unsaturated compound may be used after being treated with an acid anhydride so as to impart more excellent developing properties. The reactive unsaturated compound may be contained in an amount of 1 to 40% by weight, for example, 1 to 20% by weight based on the total amount of the photosensitive resin composition. When the reactive unsaturated compound is contained within the above range, sufficient curing occurs during exposure in the pattern forming process so that reliability is excellent, heat resistance, light resistance, and chemical resistance of the pattern are excellent, and resolution and adhesion are also excellent.

### (3) Photoinitiator

A photoradical initiator ahould be used in order to implement a negative pattern with photolithography. The photoinitiator is a photoinitiator which has a molar absorption coefficient of 10,000 L/mol·cm or more in the region of 330 to 380 nm and of which a 5% by weight loss occurs at 200°C or lower. Here, the molar extinction coefficient may be calculated by Beer-Lambert Law. In addition, the weight loss was measured while raising the temperature to 300°C at a rate of 5°C per minute under a nitrogen atmosphere using TGA.

The photoinitiator is an initiator generally used in photosensitive resin compositions, and examples thereof may include an acetophenone-based compound, a benzophenone-based compound, a thioxanthone-based compound, a benzoin-based compound, a triazine-based compound, *etc.*

Examples of the acetophenone-based compound may include 2,2'-diethoxy acetophenone, 2,2'-dibutoxy acetophenone, 2-hydroxy-2-methylpropiophenone, *p-t-*butyltrichloro acetophenone, *p*-*t*-butyldichloro acetophenone, 4-chloro acetophenone, 2,2'-dichloro-4-phenoxy acetophenone, 2-methyl-1-(4-(methylthio)phenyl)-2-morpholinopropan-1-one, 2-benzyl-2-dimethylamino-1-(4-morpholinophenyl)-butan-1-one, *etc.*

Examples of the benzophenone-based compound may include benzophenone, benzoyl benzoate, methyl benzoyl benzoate, 4-phenyl benzophenone, hydroxy benzophenone, acrylated benzophenone, 4,4'-*bis*(dimethylamino)benzophenone, 4,4'-*bis*(diethylamino)benzophenone, 4,4'-dimethylaminobenzophenone, 4,4'-dichlorobenzophenone, 3,3'-dimethyl-2-methoxybenzophenone, *etc.*

Examples of the thioxanthone-based compound may include thioxanthone, 2-chlorthioxanthone, 2-methylthioxanthone, isopropyl thioxanthone, 2,4-diethyl thioxanthone, 2,4-diisopropyl thioxanthone, 2-chlorothioxanthone, *etc.*

Examples of the benzoin-based compound may include benzoin, benzoin methyl ether, benzoin ethyl ether, benzoin isopropyl ether, benzoin isobutyl ether, benzyldimethyl ketal, *etc.*

Examples of the triazine-based compound may include 2,4,6-trichloro-*s*-triazine, 2-phenyl 4,6-*bis*(trichloromethyl)-*s*-triazine, 2-(3',4'-dimethoxystyryl)-4,6-*bis*(trichloromethyl)-s-triazine, 2-(4'-methoxynaphthyl)-4,6-*bis*(trichloromethyl)-*s*-triazine, 2-(*p*-methoxyphenyl)-4,6-*bis(*trichloromethyl)-*s*-triazine, 2-(*p*-tolyl)-4,6-bis(trichloromethyl)-*s*-triazine, 2-biphenyl 4,6-*bis*(trichloromethyl)-*s*-triazine, *bis*(trichloromethyl)-6-styryl-*s*-triazine, 2-(naphtho-1-yl)-4,6-*bis*(trichloromethyl)-*s*-triazine, 2-(4-methoxy-naphtho-1-yl)-4,6-*bis*(trichloromethyl)-*s*-triazine, 2-4-trichloromethyl(piperonyl)-6-triazine, 2-4-trichloromethyl(4'-methoxystyryl)-6-triazine, *etc.*

The photoinitiator may include carbazole-based compounds, diketone-based compounds, sulfonium borate-based compounds, diazo-based compounds, imidazole-based compounds, non-imidazole-based compounds, etc. in addition to the above compounds.

The photoinitiator may include a peroxide-based compound, an azobis-based compound, *etc.* as radical polymerization initiators.

Examples of the peroxide-based compound may include ketone peroxides such as methyl ethyl ketone peroxide, methyl isobutyl ketone peroxide, cyclohexanone peroxide, methylcyclohexanone peroxide, acetylacetone peroxide, *etc.;* diacyl peroxides such as isobutyryl peroxide, 2,4-dichlorobenzoyl peroxide, *o*-methylbenzoyl peroxide, *bis-*3,5,5-trimethylhexanoyl peroxide, *etc.;* hydroperoxides such as 2,4,4,-trimethylpentyl-2-hydroperoxide, diisopropylbenzene hydroperoxide, cumene hydroperoxide, *t*-butyl hydroperoxide, *etc.;* dialkyl peroxides such as dicumyl peroxide, 2,5-dimethyl-2,5-di(*t*-butylperoxy)hexane, 1*,*3*-bis*(*t-*butyloxyisopropyl)benzene, *t*-butylperoxyvalerate *n*-butyl ester, *etc.;* alkyl peresters such as 2,4,4-trimethylpentyl peroxyphenoxyacetate, α-cumyl peroxyneodecanoate, *t*-butyl peroxybenzoate, di-*t*-butyl peroxytrimethyl adipate, *etc.;* and percarbonates such as di-3-methoxybutyl peroxydicarbonate, di-2-ethylhexyl peroxydicarbonate, *bis*-4-*t*-butylcyclohexyl peroxydicarbonate, diisopropyl peroxydicarbonate, acetylcyclohexylsulfonyl peroxide, *t*-butyl peroxyaryl carbonate, *etc.*

Examples of the azobis-based compound may include 1,1'-azobiscyclohexan-1-carbonitrile, 2,2'-azobis(2,4-dimethylvaleronitrile), 2,2,-azobis(methylisobutyrate), 2,2'-azobis(4-methoxy-2,4-dimethylvaleronitrile), α,α'-azobis(isobutylnitrile), 4,4'-azobis(4-cyanovaleric acid), *etc.*

The photoinitiator may be used together with a photosensitizer that causes a chemical reaction by absorbing light and thus becoming an excited state and then transferring the energy of light. Examples of the photosensitizer may include tetraethylene glycol bis-3-mercaptopropionate, pentaerythritol tetrakis-3-mercaptopropionate, dipentaerythritol tetrakis-3-mercaptopropionate, etc.

The photoinitiator may be contained in an amount of 0.01 to 10% by weight, for example, 0.1 to 5% by weight based on the total amount of the photosensitive resin composition. When the photoinitiator is contained within the above range, curing occurs sufficiently during exposure in the pattern forming process so that excellent reliability may be obtained, heat resistance, light resistance, and chemical resistance of the pattern are excellent, resolution and adhesion are also excellent, and a decrease in transmittance due to an unreacted initiator may be prevented.

### (4) Colorant

All of organic and inorganic pigments and dyes can be used as the colorant.

The colorant may include a red pigment, a green pigment, a blue pigment, a yellow pigment, a black pigment, *etc.*

Examples of the red pigment may include C.I. Red Pigment 254, C.I. Red Pigment 255, C.I. Red Pigment 264, C.I. Red Pigment 270, C.I. Red Pigment 272, C.I. Red Pigment 177, C.I. Red Pigment 89, *etc.*

Examples of the green pigment may include halogen-substituted copper phthalocyanine pigments such as C.I. Green Pigment 36, C.I. Green Pigment 7, *etc.*

Examples of the blue pigment may include copper phthalocyanine pigments such as C.I. Blue Pigment 15:6, C.I. Blue Pigment 15, C.I. Blue Pigment 15:1, C.I. Blue Pigment 15:2, C.I. Blue Pigment 15:3, C.I. Blue Pigment 15:4, C.I. Blue Pigment 15:5, C.I. Blue Pigment 16, *etc.*

Examples of the yellow pigment may include isoindoline-based pigments such as C.I. Yellow Pigment 139, *etc.,* quinophthalone-based pigments such as C.I. Yellow Pigment 138, *etc.,* and nickel complex pigments such as C.I. Yellow Pigment 150, *etc.*

Examples of the black pigment may include, for example, lactam black, aniline black, perylene black, titanium black, carbon black, *etc.*

In addition, the colorant in the photosensitive resin composition according to the embodiment may include pigments, dyes, or combinations thereof. For example, the dyes may include phthalocyanine-based compounds.

The pigments and dyes may be used alone or in a mixture of two or more, but are not limited to examples thereof.

Among them, the black pigment may be used in order to effectively perform light blocking of the light blocking layer. When the black pigment is used, it may be used together with color correcting agents such as anthraquinone-based pigments, perylene-based pigments, phthalocyanine-based pigments, azo-based pigments, *etc.*

In order to disperse the pigment in the photosensitive resin composition, a dispersant may be used together. Specifically, the pigment may be surface-treated with a dispersant in advance and used, or a dispersant may be added together with the pigment and used during preparation of the photosensitive resin composition.

The dispersant may include a nonionic dispersant, an anionic dispersant, a cationic dispersant, *etc.* Specific examples of the dispersant may include polyalkylene glycol and an ester thereof, polyoxyalkylene, a polyhydric alcohol ester alkylene oxide adduct, an alcohol alkylene oxide adduct, a sulfonic acid ester, a sulfonic acid salt, a carboxylic acid ester, a carboxylic acid salt, an alkylamide alkylene oxide adduct, alkyl amine, *etc.,* and these may be used alone or in mixtures of two or more.

Examples of commercially available products of the dispersant include DISPERBYK-101, DISPERBYK-130, DISPERBYK-140, DISPERBYK-160, DISPERBYK-161, DISPERBYK-162, DISPERBYK-163, DISPERBYK-164, DISPERBYK-165, DISPERBYK-166, DISPERBYK-170, DISPERBYK-171, DISPERBYK-182, DISPERBYK-2000, DISPERBYK-2001, *etc.* from BYK; EFKA-47, EFKA-47EA, EFKA-48, EFKA-49, EFKA-100, EFKA-400, EFKA-450, *etc.* from EFKA Chemical; Solsperse 5000, Solsperse 12000, Solsperse 13240, Solsperse 13940, Solsperse 17000, Solsperse 20000, Solsperse 24000GR, Solsperse 27000, Solsperse 28000, *etc.* from Zeneka; or PB711, PB821, *etc.* from Ajinomoto.

The dispersant may be contained in an amount of 0.1 to 15% by weight based on the total amount of the photosensitive resin composition. When the dispersant is contained within the above range, stability, developing properties, and patternability of the composition are excellent when preparing the light blocking layer due to excellent dispersibility of the composition.

The pigment may be pretreated using a water-soluble inorganic salt and a wetting agent and used. When the pigment is pretreated and used as described above, the average particle diameter of the pigment may be refined.

The pretreatment may be performed through a step of kneading the pigment together with a water-soluble inorganic salt and a wetting agent, and a step of filtering and washing the pigment obtained in the kneading step.

The kneading may be performed at a temperature of 40°C to 100°C, and the filtration and washing may be performed by washing the inorganic salt using water, *etc.* and then performing filtration.

Examples of the water-soluble inorganic salt may include sodium chloride, potassium chloride, *etc.,* but are not limited thereto.

The wetting agent serves as a medium through which the pigment and the water-soluble inorganic salt may be uniformly mixed to pulverize the pigment easily, and examples of the wetting agent may include alkylene glycol monoalkyl ethers such as ethylene glycol monoethyl ether, propylene glycol monomethyl ether, diethylene glycol monomethyl ether, *etc.;* and alcohols such as ethanol, isopropanol, butanol, hexanol, cyclohexanol, ethylene glycol, diethylene glycol, polyethylene glycol, glycerin polyethylene glycol, *etc.,* and these may be used alone or in mixtures of two or more.

The pigment that has gone through the kneading step may have an average particle diameter D10 to D90 value of 60 nm to 120 nm, preferably 70 nm to 130 nm, and more preferably 80 nm to 120 nm. When the average particle diameter of the pigment is within the above range, a fine pattern may be effectively formed while having excellent heat resistance and light resistance. That is, if the size of the inorganic or organic pigment particles exceeds the above range, residue is generated after the development process, thereby reducing visibility and luminance. In addition, if the size of the inorganic pigment particles is less than the above range, it may cause a decrease in luminance and lifespan due to pixel shrinkage.

The pigment may be contained in an amount of 1 to 40% by weight, more specifically 2 to 30% by weight based on the total amount of the photosensitive resin composition. When the pigment is contained within the above range, the color reproduction rate is excellent, and the curability and adhesion of the pattern are excellent.

### (5) Solvent

The solvent may include materials which are compatible with the cardo-based resin, the reactive unsaturated compound, the pigment, the cardo-based compound, and the initiator, but do not react therewith.

Examples of the solvent include alcohols such as methanol, ethanol, *etc.;* ethers such as dichloroethyl ether, *n*-butyl ether, diisoamyl ether, methylphenyl ether, tetrahydrofuran, *etc.;* glycol ethers such as ethylene glycol monomethyl ether, ethylene glycol monoethyl ether, *etc.;* cellosolve acetates such as methyl cellosolve acetate, ethyl cellosolve acetate, diethyl cellosolve acetate, *etc.;* carbitols such as methylethyl carbitol, diethyl carbitol, diethylene glycol monomethyl ether, diethylene glycol monoethyl ether, diethylene glycol dimethyl ether, diethylene glycol methyl ethyl ether, diethylene glycol diethyl ether, *etc.;* propylene glycol alkyl ether acetates such as propylene glycol methyl ether acetate, propylene glycol propyl ether acetate, *etc*.; aromatic hydrocarbons such as toluene, xylene, *etc.;* ketones such as methyl ethyl ketone, cyclohexanone, 4-hydroxy-4-methyl-2-pentanone, methyl-*n*-propyl ketone, methyl-*n-*butyl ketone, methyl-*n*-amyl ketone, 2-heptanone, *etc*.; saturated aliphatic monocarboxylic acid alkyl esters such as ethyl acetate, *n*-butyl acetate, isobutyl acetate, *etc.;* lactic acid esters such as methyl lactate, ethyl lactate, *etc.;* oxyacetic acid alkyl esters such as methyl oxyacetate, ethyl oxyacetate, butyl oxyacetate, *etc*.; alkoxy acetate alkyl esters such as methoxy methyl acetate, methoxy ethyl acetate, methoxy butyl acetate, ethoxy methyl acetate, ethoxy ethyl acetate, *etc.;* 3-oxypropionic acid alkyl esters such as 3-oxy methyl propionate, 3-oxy ethyl propionate, *etc.;* 3-alkoxy propionic acid alkyl esters such as 3-methoxy methyl propionate, 3-methoxy ethyl propionate, 3-ethoxy ethyl propionate, 3-ethoxy methyl propionate, *etc*.; 2-oxypropionic acid alkyl esters such as methyl 2-oxypropionate, ethyl 2-oxypropionate, propyl 2-oxypropionate, *etc*.; 2-alkoxy propionic acid alkyl esters such as 2-methoxy methyl propionate, 2-methoxy ethyl propionate, 2-ethoxy ethyl propionate, 2-ethoxy methyl propionate, *etc*.; monooxy monocarboxylic acid alkyl esters of 2-oxy-2-methyl propionic acid esters such as 2-oxy-2-methyl methyl propionate, 2-oxy-2-methyl ethyl propionate, *etc.,* and 2-alkoxy-2-methyl propionic acid alkyls such as 2-methoxy-2-methyl methyl propionate, 2-ethoxy-2-methyl ethyl propionate, *etc.;* esters such as 2-hydroxyethyl propionate, 2-hydroxy-2-methyl ethyl propionate, ethyl hydroxyacetate, 2-hydroxy-3-methyl methyl butanoate, *etc.;* and ketonic acid esters such as ethyl pyruvate, *etc.*

Further, high-boiling point solvents such as *N-*methylformamide, *N,N-*dimethylformamide, *N-*methylformanilide, *N-*methylacetamide, *N,N*-dimethylacetamide, *N-*methylpyrrolidone, dimethyl sulfoxide, benzyl ethyl ether, dihexyl ether, acetylacetone, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, and phenyl cellosolve acetate may also be used.

Considering compatibility and reactivity, glycol ethers such as ethylene glycol monoethyl ether, *etc.;* ethylene glycol alkyl ether acetates such as ethyl cellosolve acetate, *etc.;* esters such as ethyl 2-hydroxypropionate, *etc.;* carbitols such as diethylene glycol monomethyl ether, *etc.*); and propylene glycol alkyl ether acetates such as propylene glycol methyl ether acetate, propylene glycol propyl ether acetate, *etc.* among the above solvents may be used .

The solvent may be contained as a balance amount based on the total amount of the photosensitive resin composition, and specifically in an amount of 40 to 90% by weight. When the solvent is contained within the above range, the processability when preparing the pattern layer is excellent as the photosensitive resin composition has an appropriate viscosity.

### (6) Other additives

In order to prevent stains or spots during application, to improve leveling performance, and to prevent the generation of residues due to nondevelopment, the photosensitive resin composition may further include additives including: malonic acid; 3-amino-1,2-propanediol; a silane-based coupling agent containing a vinyl group or (meth)acryloxy group; a leveling agent; a fluorine-based surfactant; a radical polymerization initiator; etc.

For example, the photosensitive resin composition may further include a silane-based coupling agent having a reactive substituent such as a vinyl group, a carboxyl group, a methacryloxy group, an isocyanate group, an epoxy group, or the like in order to improve adhesion to a substrate, *etc.*

Examples of the silane-based coupling agent may include trimethoxysilyl benzoic acid, γ-methacryloxypropyl trimethoxysilane, vinyl triacetoxysilane, vinyl trimethoxysilane, γ-isocyanate propyl triethoxysilane, γ-glycidoxy propyl trimethoxy silane, β-epoxy cyclohexyl ethyl trimethoxy silane, *etc.,* and these may be used alone or in mixtures of two or more.

The silane-based coupling agent may be contained in an amount of 0.01 part by weight to 10 parts by weight based on 100 parts by weight of the photosensitive resin composition. When the silane-based coupling agent is contained within the above range, adhesion, storability, *etc.* are excellent.

In addition, the photosensitive resin composition may further include a surfactant, for example, a fluorine-based surfactant for the effects of improving coating properties and preventing creation of defects, if necessary.

The fluorine-based surfactant may include fluorine-based surfactants commercially available under the names of: BM-1000^{®}, BM-1100^{®}, *etc.* from BM Chemie; Megaface F 142D^{®}, Megaface F 172^{®}, Megaface F 173^{®}, Megaface F 183^{®}, *etc.* from Dainippon Ink Kagaku Kogyo; Fluorad FC-135^{®}, Fluorad FC-170C^{®}, Fluorad FC-430^{®}, Fluorad FC-431^{®}, *etc.* from Sumitomo 3M; Saffron S-112^{®}, Saffron S-113^{®}, Saffron S-131^{®}, Saffron S-141^{®}, Saffron S-145^{®}, *etc.* from Asahi Grass; and SH-28PA^{®}, SH-190^{®}, SH-193^{®}, SZ-6032^{®}, SF-8428^{®}, *etc.* from Toray Silicone.

The surfactant may be used in an amount of 0.001 to 5 parts by weight based on 100 parts by weight of the photosensitive resin composition. When the surfactant is contained within the above range, coating uniformity may be secured, stains may not occur, and wetting to the glass substrate is excellent. In addition, a certain amount of other additives such as antioxidants and stabilizers may be added to the photosensitive resin composition within a range that does not impair physical properties.

In another embodiment, patterning may be performed on the pixel separation part of the organic light emitting device electrode using the photosensitive resin composition described above.

Hereinafter, Synthesis Examples and Examples according to the present disclosure will be described in detail, but Synthesis Examples and Examples of the present disclosure are not limited thereto.

### Synthesis Example 1: (Preparation of 9,9-bis[4-(glycidyloxy)phenyl]fluorene of Formula 8)

25 g of 9,9-bis[4-(glycidyloxy)phenyl]fluorene of Formula 8 below was obtained by adding 20 g of 9,9'-bisphenol fluorene (Sigma Aldrich), 8.67 g of glycidyl chloride (Sigma Aldrich), and 30 g of anhydrous potassium carbonate together with 100 mL of dimethylformamide into a 300 mL 3-neck round-bottom flask having a distillation tube installed thereon, raising the temperature to 80°C to perform reaction for 4 hours, lowering the temperature to 25°C to filter the reaction solution, adding the filtrate dropwise to 1,000 mL of water while performing stirring, filtering the precipitated powder, washing the filtered precipitated powder with water, and drying it under reduced pressure at 40°C. As a result of purity analysis of the obtained powder by HPLC, a purity of 98% was shown.

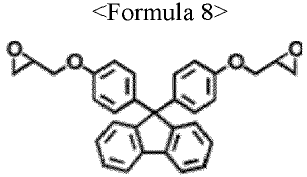

### Synthesis Example 2: Preparation of cardo-based binder resin

25g (54 mmol) of Compound 1 obtained in Synthesis Example 1, 8 g of acrylic acid (Daejung Chemicals & Metals Co., Ltd.), 0.2 g of benzyltriethylammonium chloride (Daejung Chemicals & Metals Co., Ltd.), and 0.2 g of hydroquinone (Daejung Chemicals & Metals Co., Ltd.) together with 52 g of propylene glycol methyl ether acetate (Sigma Aldrich) were added into a 300 mL 3-neck round-bottom flask having a distillation tube installed thereon, and stirring was performed at 110°C for 6 hours. After completion of the reaction, 8 g of biphenyltetracarboxylic dianhydride (Mitsubishi Gas) and 1.8 g of tetrahydrophthalic acid (Sigma Aldrich) were added thereto, and then stirring was performed again at 110°C for 6 hours. After completion of the reaction, a cardo-based binder resin having a molecular weight of 4,580 and a solid content of 45% was obtained as a result of recovering the reaction solution and performing analysis.

### Preparation Example 1: Preparation of Black Pigment Dispersion

A dispersion was obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 8 hours using a paint shaker (Asada) of 100 g of zirconia beads with a diameter of 0.5 mm (Toray). The relevant dispersion could be confirmed to have an average particle size (Mean) of 119.7 nm through a particle size analyzer (SZ-100Z, HORIBA).

### Preparation Example 2: Preparation of Black Pigment Dispersion

A dispersion was obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 9 hours using a paint shaker (Asada) of 100 g of zirconia beads with a diameter of 0.5 mm (Toray). The relevant dispersion could be confirmed to have an average particle size (Mean) of 105.6 nm through a particle size analyzer (SZ-100Z, HORIBA).

### Preparation Example 3: Preparation of Black Pigment Dispersion

A dispersion was obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 10 hours using a paint shaker (Asada) of 100 g of zirconia beads with a diameter of 0.5 mm (Toray). The relevant dispersion could be confirmed to have an average particle size (Mean) of 81.8 nm through a particle size analyzer (SZ-100Z, HORIBA).

### Preparation Example 4: Preparation of Black Pigment Dispersion

A dispersion was obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 7 hours using a paint shaker (Asada) of 100 g of zirconia beads with a diameter of 0.5 mm (Toray). The relevant dispersion could be confirmed to have an average particle size (Mean) of 136.8 nm through a particle size analyzer (SZ-100Z, HORIBA).

### Preparation Example 5: Preparation of Black Pigment Dispersion

A dispersion was obtained by dispersing 15 g of Irgaphor Black S 100 CF (black pigment/BASF), 8.5 g of Disperbyk 163 (BYK), and 6.5 g of SR-3613 (SMS) together with 70 g of propylene glycol methyl ether acetate for 11 hours using a paint shaker (Asada) of 100 g of zirconia beads with a diameter of 0.5 mm (Toray). The relevant dispersion could be confirmed to have an average particle size (Mean) of 75.3 nm through a particle size analyzer (SZ-100Z, HORIBA).

Photosensitive resin composition solutions were prepared with the compositions as shown in Table 1 below.

Specifically, after the initiator was dissolved in a solvent, and then stirring was performed at room temperature, and then a binder resin and a polymerizable compound were added thereto to perform stirring at room temperature. Subsequently, a colorant and other additives were added to the obtained reactants, and stirring was performed at room temperature. Subsequently, the reaction products were filtered three times to remove impurities, thereby preparing photosensitive resin compositions.

**[Table 1]**

| | Example 1 | Example 2 | Example 3 | Comparative Example 1 | Comparative Example 2 |
|---|---|---|---|---|---|
| Black Pigment Dispersion (Preparation Example 1) | 23 | | | | |
| Black Pigment Dispersion (Preparation Example 2) | | 23 | | | |
| Black Pigment Dispersion (Preparation Example 3) | | | 23 | | |
| Black Pigment Dispersion (Preparation Example 4) | | | | 23 | |
| Black Pigment Dispersion (Preparation Example 5) | | | | | 23 |
| Cardo Binder (Synthesis Example 2) | 15 | 15 | 15 | 15 | 15 |
| Miraemer M600 (Miwon Specialty Chemical) | 12.5 | 12.5 | 12.5 | 12.5 | 12.5 |
| PBG-304 (Trony) | 0.5 | 0.5 | 0.5 | 0.5 | 0.5 |
| Propylene Glycol Methyl Ether Acetate | 49 | 49 | 49 | 49 | 49 |

The method for preparing a negative pixel defining layer (PDL) using the photosensitive resin composition is as follows.

### (1) Application and coating steps

A coating film is formed by removing a portion of the solvent using vacuum chamber dry (VCD) after applying a photosensitive resin composition to a certain thickness onto a substrate on which a washed 10 cm* 10 cm metal has been deposited using a spin coater. The photosensitive resin composition is coated to a coating thickness of 3.3 micrometers to 3.5 micrometers after VCD to form the coating film.

### (2) Pre-baking step

In order to remove the solvent contained in the obtained coating film, the film is heated on a hot plate at 80°C to 120°C for 50 seconds to 200 seconds. A certain amount of the solvent in the relevant process may be removed, thereby reducing contamination of a pixel-shaped mask and forming a clean type pattern during the exposure step of the relevant process.

### (3) Exposure step

After interposing a pixel-shaped mask to form a pattern required for the obtained coating film and obtain a constant thickness, a pattern may be formed by irradiating an active ray of 190 nm to 600 nm, preferably a light source of a metal or LED lamp having a ghi-line through an exposure machine. The exposure amount irradiated for pattern formation is 20 to 150 mJ/cm², and it is a negative-type photoresist material to be formed. A pattern was formed in a state where transmittance of the photomask used during exposure had three transmittance sections of 0% (non-exposed portion), 20 to 50% (half-tone), and 100% (full-tone).

### (4) Developing step

Following the exposure step, after development is performed for 30 to 60 seconds by a method of dipping the coating film in tetramethylammonium hydroxide (TMAH) as a developer at 23 ± 2°C for a certain period of time (minutes), when washing is performed using ultrapure water (DI water), the non-exposed portion is dissolved and removed so that only the exposed portion remains to form an image pattern, and the thickness of the coating film is 1.30 to 1.95 µm based on half-tone and 3.20 to 3.40 µm based on full-tone.

### (5) Post-exposure step

Following the developing step, in order to prevent the pattern from collapsing after post-heat treatment, the strength of the coating film may be increased by irradiating the entire area with a light source of a metal or LED lamp having an active ray of 190 nm to 600 nm, preferably a ghi-line, through an exposure machine without a photomask. The exposure amount irradiated to increase the strength is 50 to 1,000 mJ/cm².

### (6) Post-heat treatment step

In order to obtain the image pattern obtained by the post-exposure treatment, post-heat treatment (post baking) is performed in an oven at 200 to 300°C for 30 to 120 minutes to completely remove the solvent, and the pattern is cured to form a film. Afterwards, measurement is performed using a scanning microscope.

### (7) Pattern and taper angle analysis

After forming a pattern on the substrate using the photosensitive resin composition through the steps (1) to (6) above, the thicknesses of the pattern cross-sections (half-tone) according to the size of the average particle size of the inorganic pigment using a scanning electron microscope (JEOL) were compared.

### (8) Particle size measurement

The pigment dispersions prepared in Preparation Examples 1 to 5 above were diluted 3,000 times in a PGMEA solvent to prepare measurement samples, and the particle sizes were respectively measured using HORIBA's SZ-100Z. During measurement, D₁₀, D₅₀, and D₉₀ values were obtained, and the average pigment size was defined as the mean value, which is the average of all.

**[Table 2]**

| Post-heat treatment process (@ 250°C) | Example 1 (Preparation Example 1) | Example 2 (Preparation Example 2) | Example 3 (Preparation Example 3) | Comparative Example 1 (Preparation Example 4) | Comparative Example 2 (Preparation Example 5) |
|---|---|---|---|---|---|
| Particle size (D₁₀) | 89.2 | 79.2 | 61.7 | 102.4 | 56.1 |
| Particle size (D₅₀) | 119.6 | 105.9 | 82.0 | 136.5 | 75.7 |
| Particle size (D₉₀) | 150.3 | 131.7 | 101.7 | 171.5 | 94.1 |
| Particle size (Mean) | 119.7 | 105.6 | 81.8 | 136.8 | 75.3 |
| F/T thickness (µm) | 3.08 | 3.02 | 2.93 | 3.22 | 2.78 |
| H/T thickness (µm) | 1.77 | 1.54 | 1.26 | 1.91 | 0.99 |
| Residue | Non-existence | Non-existence | Non-existence | Existence | Non-existence |

| | | | | | |
|---|---|---|---|---|---|
| *1) H/T: Half-tone, *2) F/T: Full-tone | | | | | |

The thicknesses of the lower and upper pattern cross sections of the patterns formed for each average particle size of the inorganic pigment were measured and compared. Referring to Comparative Example 1 in Table 2, it could be confirmed due to the large particle size that the half-tone thickness was somewhat high at 1.91 µm and the full-tone thickness was somewhat high at 3.22 µm. If the half-tone thickness exceeds 1.90 µm, the illuminance increases and residue is generated so that a disadvantage of poor visibility occurs.

Referring to Comparative Example 2, the opposite trend to Comparative Example 1 could be confirmed, and it could be confirmed due to the small particle size that the half-tone thickness was 0.99 µm and the full-tone thickness was 2.78 µm. If the thickness of the half-tone PDL becomes less than 1.00 µm, from the light blocking perspective, since light reflected from the lower TFT electrode is not completely blocked when it is seen from the light blocking side, a disadvantage of color interference or lowered luminance occurs.

Therefore, it is necessary that the half-tone thickness be maintained between 1.00 µm and 1.90 µm. Referring to Examples 1 to 3, the average particle size of the inorganic pigment is 80 nm to 120 nm, the full-tone thickness is 2.90 µm to 3.10 µm, and the half-tone thickness is 1.20 µm to 1.80 µm. It could be confirmed that there was no residue in Examples 1 to 3.

The above description is merely illustrative of the present disclosure, and those skilled in the art to which the present disclosure pertains will be able to make various modifications without departing from the essential characteristics of the present disclosure.

Accordingly, the embodiments disclosed in this specification are for illustrative purposes only and are not intended to limit the present disclosure, and the spirit and scope of the present disclosure are not limited by these embodiments. The scope of protection of the present disclosure should be interpreted in accordance with the claims, and all technologies within the scope equivalent thereto should be interpreted as being included in the scope of rights of the present disclosure.

## Claims

1. A method for preparing a pixel defining layer, the method comprising steps of: applying and coating a photosensitive resin composition containing a colorant with an average particle size of 60 nm to 140 nm; performing prebaking; performing exposure; performing development; performing post-exposure; and performing post-heat treatment, wherein the post-heat treatment step is performed at an oven temperature of 200°C to 300°C for 30 to 120 minutes, the full-tone thickness after the post-heat treatment step is 2.80 µm to 3.20 µm, the half-tone thickness after the post-heat treatment step is 1.00 µm to 1.90 µm, and there is no residue.

2. The method of claim 1, wherein the colorant includes one or more of an inorganic dye, an organic dye, an inorganic pigment, and an organic pigment.

3. The method of claim 1 or 2, wherein the colorant is pretreated using a dispersant; or a water-soluble inorganic salt and a wetting agent.

4. The method of any one of claims 1 to 3, wherein the half-tone thickness of the pattern after the development step is 1.40 to 2.00 µm.

5. The method of any one of claims 1 to 4, wherein the full-tone thickness of the pattern after the development step is 3.20 to 3.42 µm.

6. The method of any one of claims 1 to 5, wherein the hot plate temperature in the prebaking step is 90°C to 120°C.

7. The method of any one of claims 1 to 6, wherein the prebaking step is performed for 100 to 150 seconds.

8. The method of any one of claims 1 to 7, wherein the development step is performed for 35 to 55 seconds.

9. The method of any one of claims 1 to 8, wherein the exposure step is irradiating an energy of 80 to 110 mJ/cm².

10. The method of any one of claims 1 to 9, wherein the post-exposure step is irradiating the entire area with an exposure energy of 100 to 900 mJ/cm² having the same active ray of 190 nm to 600 nm as the exposure step without a mask.

11. The method of any one of claims 1 to 10, wherein the photosensitive resin composition comprises a patterning resin which includes an acrylic binder resin, a cardo-based binder resin, or a combination thereof.

12. A pixel defining layer prepared according to the preparation method of any one of claims 1 to 11.

13. An organic light emitting display device comprising the pixel defining layer according to claim 12.

14. An electronic device comprising the display device of claim 13 and a control unit for driving the display device.
